# EUROPEAN PATENT APPLICATION

(11) **EP 4 734 715 A1**
(43) Date of publication of application: **29.04.2026**
(21) Application number: 25210050.8
(22) Date of filing: 21.10.2025
(51) Int. Cl.: H10H 20/01, H10H 20/85, H10H 20/853, H10H 20/857, H10H 20/84

(54) **LIGHT-EMITTING PACKAGE STRUCTURE AND METHOD FOR PRODUCING THE SAME**

(30) Priority: 22.10.2024 US 202463710032 P; 26.09.2025 US 202519340893
(71) Applicant: Lite-On Technology Corporation, Taipei City 11492 (TW)
(72) Inventor: TSAI, Ming-Sung, Taipei City (TW); LEE, Cheng-Ying, Taipei City (TW); SU, Wei-Le, Taipei City (TW); TSAI, Jie-Ting, Taipei City (TW)
(74) Representative: Viering, Jentschura & Partner mbB Patent- und Rechtsanwälte

(57) **Abstract**

A light-emitting package structure (100) and a method for producing the same. The light-emitting package structure (100) includes a substrate (1), a light-emitting module (2), and an encapsulant (3). The substrate (1) has a first top surface (1a) and a first bottom surface (1b) opposite to each other and a plurality of first side surfaces (1c). The substrate (1) has a first conductive layer (11) and a second conductive layer (12) respectively formed on the first top surface (1a) and the first bottom surface (1b). The light-emitting module (2) is disposed on the first conductive layer (11). The encapsulant (3) covers the first conductive layer (11), a plurality of side surfaces of the light-emitting module (2), and the first top surface (1a) and the first side surfaces (1c) of the substrate (1).

## Description

### FIELD OF THE INVENTION

The present invention relates to a light-emitting package structure and method for producing the same, and more particularly to a light-emitting package structure with a plurality of sides surfaces of a substrate being covered and method for producing the same.

### BACKGROUND OF THE INVENTION

In a conventional light-emitting package structure, since a plurality of side surfaces of a substrate are usually not covered by an encapsulant, the encapsulant cannot provide a sufficient protective effect. Accordingly, the conventional light-emitting package structure is easily damaged during transportation or installation and has poor insulation and moisture resistance.

### SUMMARY OF THE INVENTION

In response to the above-referenced technical inadequacy, the present invention provides a light-emitting package structure and method for producing the same, so as to improve on the problem of insufficient protective effect provided by an encapsulant in a conventional light-emitting package structure, since a plurality side surfaces of a substrate are usually not covered by the encapsulant.

In order to solve the above-mentioned problems, one of the technical aspects adopted by the present invention is to provide a light-emitting package structure. The light-emitting package structure includes a substrate, a light-emitting module, an encapsulant, and a light-penetrable layer. The substrate has a first top surface and a first bottom surface opposite to each other and a plurality of first side surfaces. A first conductive layer is formed on the first top surface and a second conductive layer is formed on the first bottom surface. The light-emitting module is disposed on the first conductive layer. The encapsulant covers the first conductive layer, a plurality of side surfaces of the light-emitting module, and the first top surface and the plurality of first side surfaces of the substrate.

In order to solve the above-mentioned problems, yet another one of the technical aspects adopted by the present invention is to provide a method for producing a light-emitting package structure. The method includes a preparing process, a first packaging process, a first cutting process, a second packaging process, a second cutting process, and a first light-penetrable layer forming process. The preparing process is implemented by providing a carrier board having a top surface and a bottom surface opposite to each other. The carrier board has a first conductive layer and a second conductive layer respectively formed on the top surface and the bottom surface. The first packaging process is implemented by placing a plurality of light-emitting modules onto the first conductive layer on the carrier board and forming a first encapsulant on the top surface. The first encapsulant covers a plurality of side surfaces of the light-emitting module. The first cutting process is implemented by placing the carrier board onto a working platform with the top surface of the carrier board facing toward the working platform and cutting the carrier board from the bottom surface thereof, so as to form a plurality of cutting grooves penetrating through the carrier board. After the first cutting process, the carrier board is formed into a plurality of substrates, and each of the plurality of substrates has a first top surface and a first bottom surface opposite to each other. The second packaging process is implemented by covering a plurality of first side surfaces of each of the plurality of substrates by an encapsulation material and curing the encapsulation material so as to form a second encapsulant. The first encapsulant is connected to the second encapsulant, and an interface is formed between the first encapsulant and the second encapsulant. The second cutting process is implemented by cutting the first encapsulant and the second encapsulant from the plurality of cutting grooves. The first light-penetrable layer forming process is implemented by forming a first light-penetrable layer at a surface of each of the plurality of the light-emitting modules away from a corresponding one of the plurality of substrates, so as to form a light-emitting package structure.

Therefore, in the light-emitting package structure and method for producing the same provided by the present invention, by virtue of "the encapsulant covering the first top surface, the first conductive layer, and the plurality of first side surfaces of the substrate," the problem of the encapsulant in the conventional light-emitting package structure having an insufficient protective effect, since the side surfaces of the substrate are usually not covered by the encapsulant, can be effectively improved.

These and other aspects of the present invention will become apparent from the following description of the embodiment taken in conjunction with the following drawings and their captions, although variations and modifications therein may be affected without departing from the spirit and scope of the novel concepts of the invention.

### BRIEF DESCRIPTION OF THE DRAWINGS

The described embodiments may be better understood by reference to the following description and the accompanying drawings, in which:
FIG. 1 is a schematic perspective view of a light-emitting package structure according to a first embodiment of the present invention;
FIG. 2 is a schematic exploded view of the light-emitting package structure according to the first embodiment of the present invention;
FIG. 3 is a schematic side view of the light-emitting package structure according to the first embodiment of the present invention;
FIG. 4 is a schematic side view of a light-emitting package structure according to a second embodiment of the present invention;
FIG. 5 is a schematic perspective view of a light-emitting package structure according to a third embodiment of the present invention;
FIG. 6 is a schematic side view of the light-emitting package structure according to the third embodiment of the present invention;
FIG. 7 is a schematic side view of a light-emitting package structure according to a fourth embodiment of the present invention;
FIG. 8 is a schematic perspective view of a light-emitting package structure according to a fifth embodiment of the present invention;
FIG. 9 is a schematic side view of the light-emitting package structure according to the fifth embodiment of the present invention;
FIG. 10 is a schematic side view of the light-emitting package structure according to a sixth embodiment of the present invention;
FIG. 11 is a schematic perspective view of a light-emitting package structure according to a seventh embodiment of the present invention;
FIG. 12 is a schematic side view of the light-emitting package structure according to the seventh embodiment of the present invention;
FIG. 13 is a schematic side view of a light-emitting package structure according to an eighth embodiment of the present invention;
FIG. 14 is a flow chart of a method for producing a light-emitting package structure according to a ninth embodiment of the present invention;
FIG. 15 is a schematic view showing a first packaging process of the method for producing the light-emitting package structure according to the ninth embodiment of the present invention;
FIG. 16 is a schematic view showing a first cutting process of the method for producing the light-emitting package structure according to the ninth embodiment of the present invention;
FIG. 17 is a schematic view showing a second packaging process of the method for producing the light-emitting package structure according to the ninth embodiment of the present invention;
FIG. 18 is a schematic view showing a second cutting process of the method for producing the light-emitting package structure according to the ninth embodiment of the present invention;
FIG. 19 is a schematic view showing a first cutting process of a method for producing a light-emitting package structure according to a tenth embodiment of the present invention; and
FIG. 20 is a schematic view showing a second packaging process of the method for producing the light-emitting package structure according to the tenth embodiment of the present invention.

### DETAILED DESCRIPTION OF THE EXEMPLARY EMBODIMENTS

The present invention is more particularly described in the following examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a," "an" and "the" includes plural reference, and the meaning of "in" includes "in" and "on." Titles or subtitles can be used herein for the convenience of a reader, which shall have no influence on the scope of the present invention.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present invention or of any exemplified term. Likewise, the present invention is not limited to various embodiments given herein. Numbering terms such as "first," "second" or "third" can be used to describe various components, signals or the like, which are for distinguishing one component/signal from another one only, and are not intended to, nor should be construed to impose any substantive limitations on the components, signals or the like.

### [Light-Emitting Package Structure]

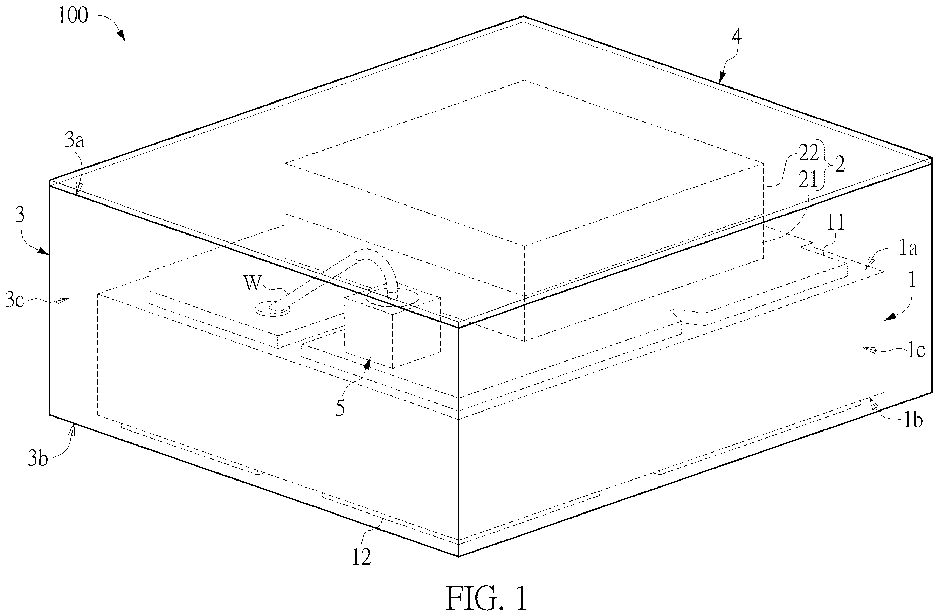

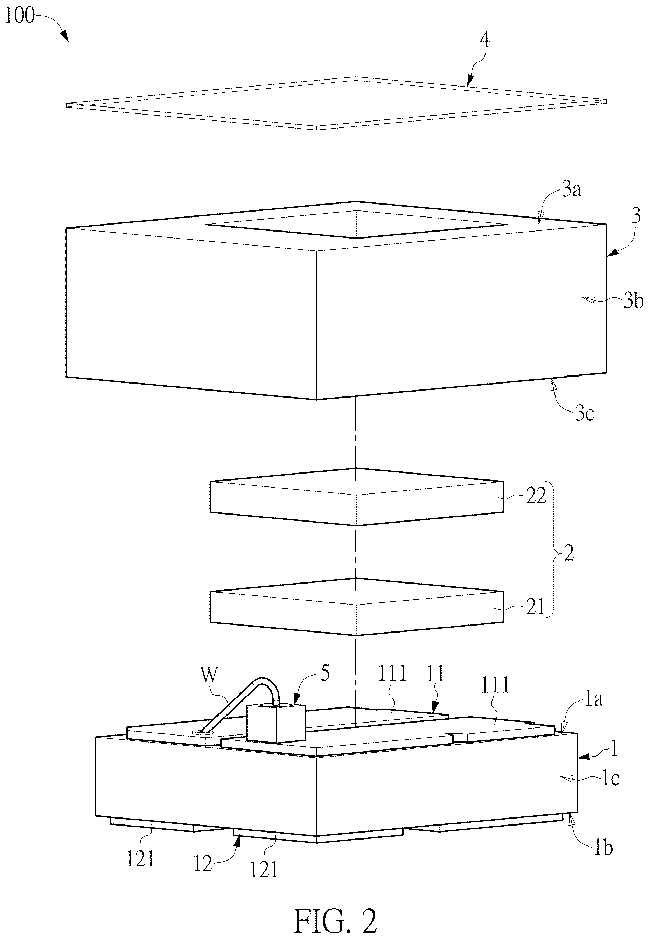

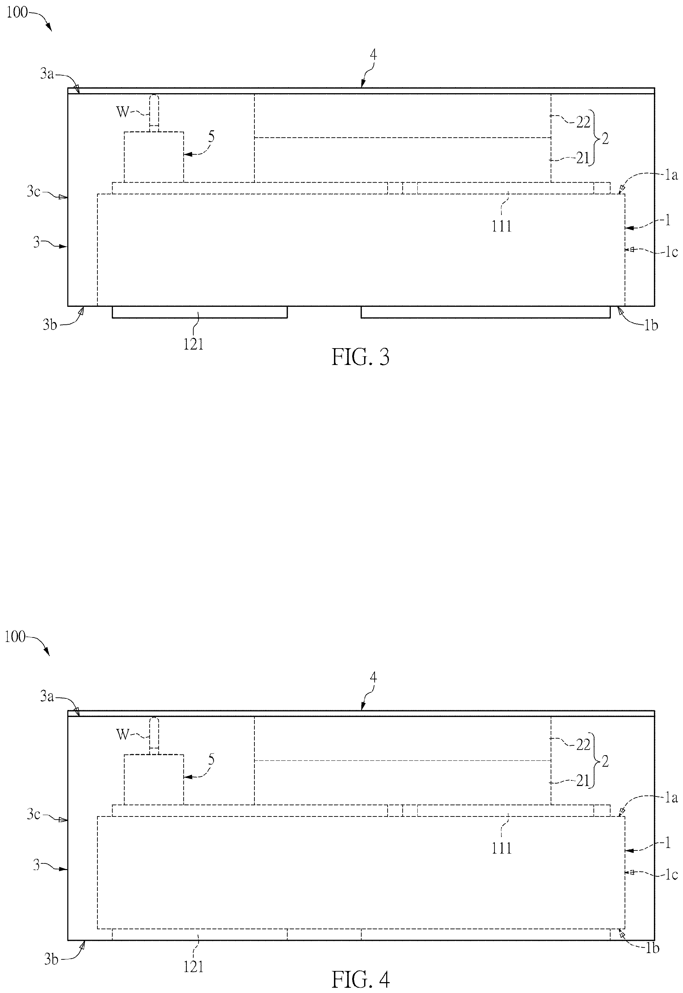

Referring to FIG. 1 to FIG. 3, FIG. 1 is a schematic perspective view of a light-emitting package structure according to a first embodiment of the present invention, FIG. 2 is a schematic exploded view of the light-emitting package structure according to the first embodiment of the present invention, and FIG. 3 is a schematic side view of the light-emitting package structure according to the first embodiment of the present invention. A first embodiment of the present invention provides a light-emitting package structure 100. The light-emitting package structure 100 includes a substrate 1, a light-emitting module 2, an encapsulant 3, and a light-penetrable layer 4. The substrate 1 can be, for example, a ceramic substrate or be made of a silicone molding compound (i.e., SMC), but the present invention is not limited thereto. The substrate 1 has a first top surface 1a and a first bottom surface 1b opposite to each other and a plurality of first side surfaces 1c. In addition, a first conductive layer 11 is formed on the first top surface 1a and a second conductive layer 12 is formed the first bottom surface 1b.

The light-emitting package structure 100 can further include a Zener diode 5, and the Zener diode 5 is disposed on the first conductive layer 11. Specifically, the first conductive layer 11 can include a plurality of first circuit layers 111, the Zener diode 5 can be disposed on one of the first circuit layers 111, and the Zener diode 5 can be connected to another one of the first circuit layers 111 through a wire W. In other embodiments, the substrate 1 can be provided without the wire W or the Zener diode 5.

The light-emitting module 2 can be disposed on the first circuit layers 111 of the first conductive layer 11. The light-emitting module 2 includes a light-emitting member 21 and a light-penetrable member 22, and the light-emitting member 21 is disposed between the substrate 1 and the light-penetrable member 22.

For example, the light-emitting member 21 can be a light-emitting chip, and the light-penetrable member 22 can be a transparent glass, a phosphor in glass (i.e., PIG), a ceramic-based phosphor layer, or an epoxy resin. In the present embodiment, a plurality of side surfaces of the light-emitting member 21 can be flush with a plurality of side surfaces of the light-penetrable member 22, but the present invention is not limited thereto. In other embodiments, the side surfaces of the light-emitting member 21 can be recessed from the side surfaces of the light-penetrable member 22.

In the present embodiment, the light-emitting member 21 is configured to emit a first light beam, and a first wavelength range of the first light beam can be between 10 nm and 780 nm. In one embodiment, the first wavelength range can be between 380 nm and 780 nm (i.e., visible light wavelength range). In one embodiment the first wavelength range can be between 422 nm and 457.5 nm (i.e., blue light wavelength range). In one embodiment. In one embodiment the first wavelength range can be between 10 nm and 420 nm (i.e., invisible UV wavelength range). In one embodiment, the first wavelength range is between 270 nm and 420 nm (i.e., invisible IR wavelength range).

The first light beam passes through the light-penetrable member 22 and is formed into a second light beam, and the second light beam has a second wavelength of between 380 nm and 780 nm, but the present embodiment is not limited thereto. In one embodiment, the second wavelength can be substantially equivalent to the first wavelength.

The encapsulant 3 covers the first conductive layer 11, a plurality of side surfaces of the light-emitting module 2, and the first top surface 1a and the first side surfaces 1c of the substrate 1. In other words, the first top surface 1a, the first conductive layer 11, and the first side surfaces 1c can be not exposed from the encapsulant 3. In the present embodiment, a second top surface 3a of the encapsulant can be flush with (or co-planar with) a surface of the light-emitting module 2 that is away from the substrate 1, but the present invention is not limited thereto.

The light-penetrable layer 4 is disposed on the surface of the light-emitting module 2 that is away from the substrate 1. Specifically, the light-penetrable layer 4 can cover the light-penetrable member 22 of the light-emitting module 2 and the second top surface 3a of the encapsulant 3. In the present embodiment, the light-penetrable layer 4 can be an organic light-penetrable layer with materials who have characteristics of high transparency, thin, well-being within extreme conditions and waterproof. The penetrable layer could be made of an amorphous fluoropolymer (e.g. CYTOP^{®}), Trioctylphosphine sulfide (e.g. CYTOP 505), perfluoroalkoxy (FPA) or their alternatives, or a fluorine-based moisture-proof adhesive (e.g., WOP), but the present invention is not limited thereto. In the present embodiment, the light-penetrable layer 4 has a refractive index of between 1.2 and 1.6, but the present invention is not limited thereto.

Referring to FIG. 4, FIG. 4 is a schematic side view of a light-emitting package structure according to a second embodiment of the present invention. In a second embodiment of the present invention, the encapsulant 3 further covers the first bottom surface 1b of the substrate 1 and a plurality of side surfaces of the second conductive layer 12, and the second conductive layer 12 is partially exposed from the encapsulant 3. More specifically, the second conductive layer 12 can include a plurality of second circuit layers 121, and a surface of each of the second circuit layers 121 away from the substrate 1 is not covered by the encapsulant 3. In other words, the first top surface 1a, the first conductive layer 11, the first side surfaces 1c, and the first bottom surface 1b of the substrate 1 are not exposed from the encapsulant 3.

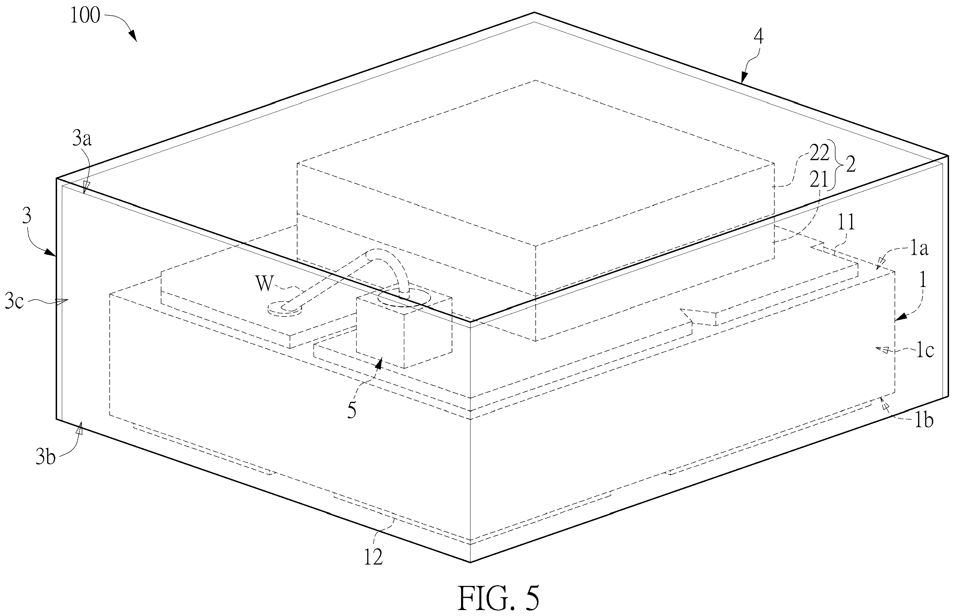

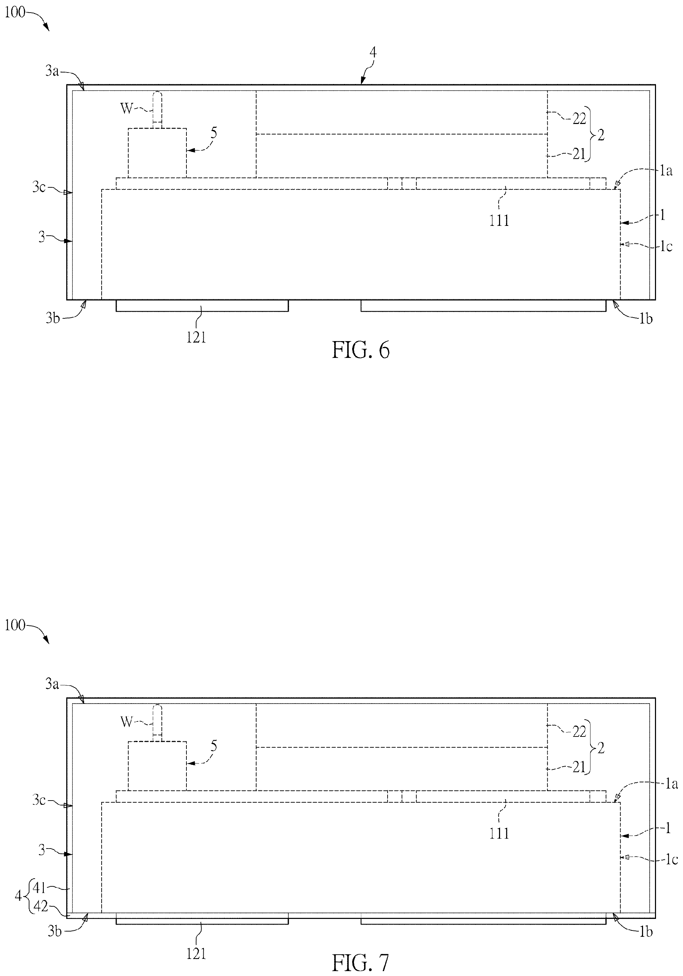

Referring to FIG. 5 and FIG. 6, FIG. 5 is a schematic perspective view of a light-emitting package structure according to a third embodiment of the present invention, and FIG. 6 is a schematic side view of the light-emitting package structure according to the third embodiment of the present invention. In a third embodiment of the present invention, the light-penetrable layer 4 covers the light-emitting module 2 and the second top surface 3a and a plurality of second side surfaces 3c of the encapsulant 3.

Referring to FIG. 7, FIG. 7 is a schematic side view of a light-emitting package structure according to a fourth embodiment of the present invention. In a fourth embodiment of the present invention, the light-penetrable layer 4 includes a first light-penetrable layer 41 and a second light-penetrable layer 42, the first light-penetrable layer 41 covers the light-emitting module 2 and the second top surface 3a and the second side surfaces 3c of the encapsulant 3, and the second light-penetrable layer 42 is connected to the first light-penetrable layer 41 and covers a second bottom surface 3b of the encapsulant 3. In other words, in the present embodiment, the encapsulant 3 can be entirely covered by the first light-penetrable layer 41 and the second light-penetrable layer 42. In addition, the second light-penetrable layer 42 can further cover the first bottom surface 1b of the substrate 1.

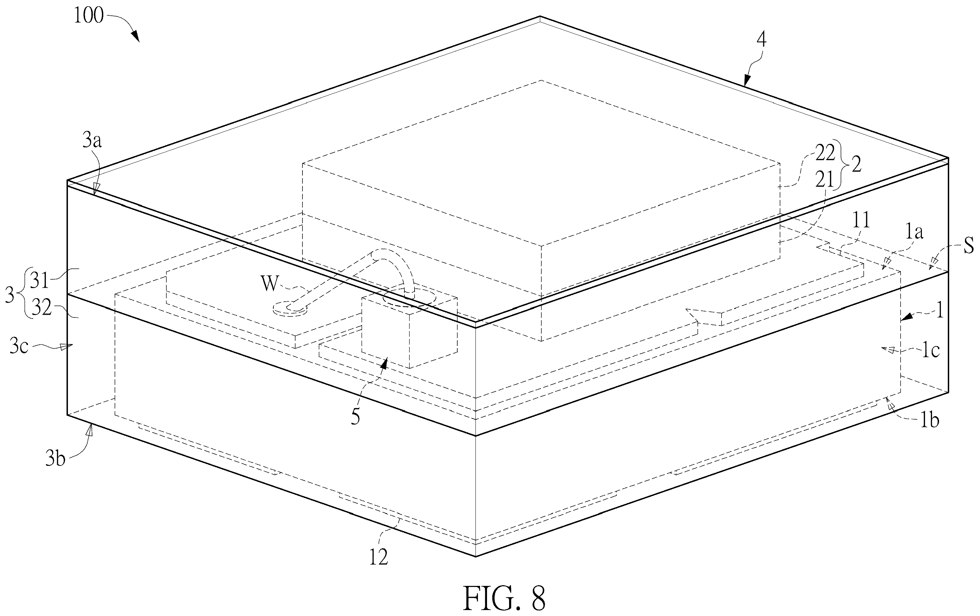

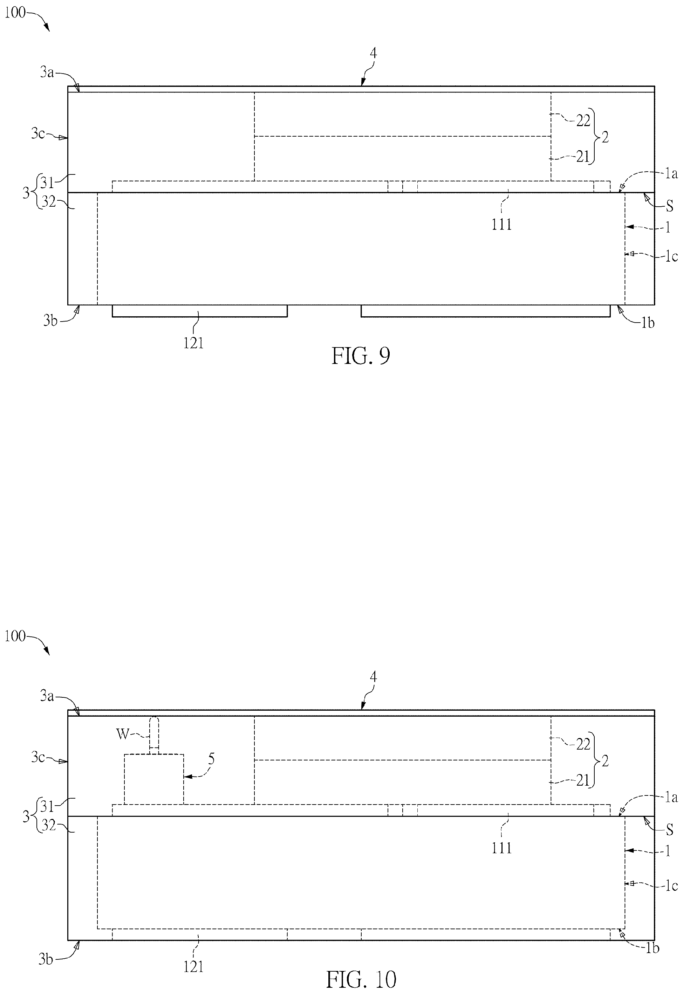

Referring to FIG. 8 and FIG. 9, FIG. 8 is a schematic perspective view of a light-emitting package structure according to a fifth embodiment of the present invention, and FIG. 9 is a schematic side view of the light-emitting package structure according to the fifth embodiment of the present invention. In a fifth embodiment of the present invention, the encapsulant 3 is defined to include a first encapsulant 31 and a second encapsulant 32. The first encapsulant 31 covers the first top surface 1a, the first conductive layer 11, and the light-emitting module 2. The second encapsulant 32 is connected to the first encapsulant 31 and covers the first side surfaces 1c of the substrate 1, and an interface S is formed between the first encapsulant 31 and the second encapsulant 32. In addition, a top surface of the first encapsulant 31 and the surface of the light-emitting module 2 that is away from the substate 1 can be co-planar, and the second encapsulant 32 can cover the side surfaces of the second conductive layer 12.

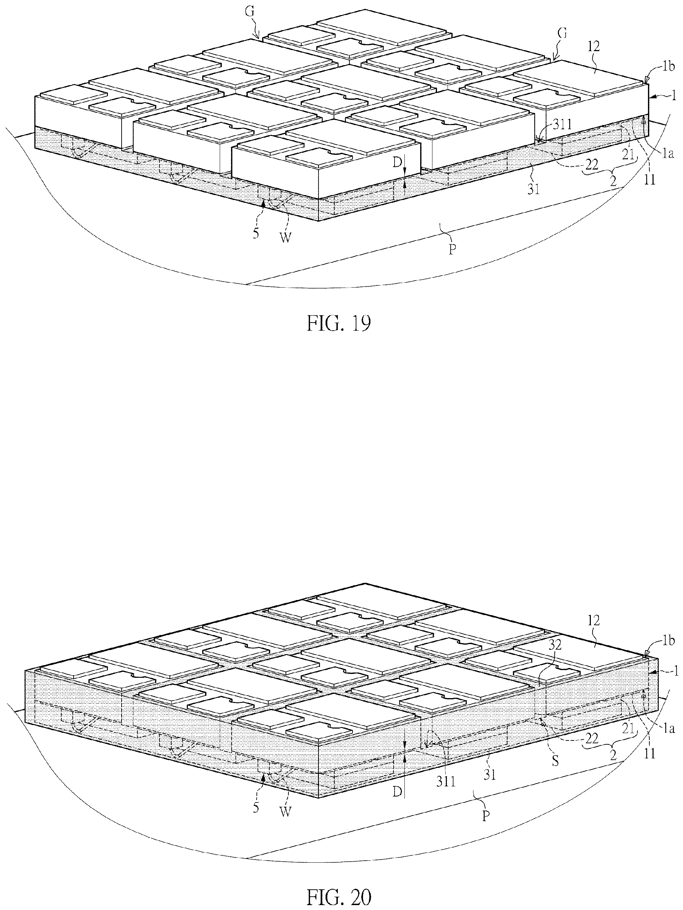

The interface S can be substantially flush with the first top surface 1a of the substrate 1, but the present invention is not limited thereto. In other embodiments, the interface S can be not flush with the first top surface 1a of the substrate 1. For example, a distance between the interface S and a surface of the first encapsulant 31 away from the substrate 1 can be less than a distance between the first top surface 1a and the above-mentioned surface of the first encapsulant 31 (as shown in FIG. 19 and FIG. 20), but the present invention is not limited thereto.

The light-penetrable layer 4 is disposed on the surface of the light-emitting module 2 that is away from the substrate 1. Specifically, the light-penetrable layer 4 can cover the light-emitting module 2 and a surface of the first encapsulant 31 that is away from the second encapsulant 32.

Referring to FIG. 10, FIG. 10 is a schematic side view of the light-emitting package structure according to a sixth embodiment of the present invention. In a sixth embodiment of the present invention, the second encapsulant 32 further covers the first bottom surface 1b of the substrate 1, and the second conductive layer 12 is exposed from the second encapsulant 32.

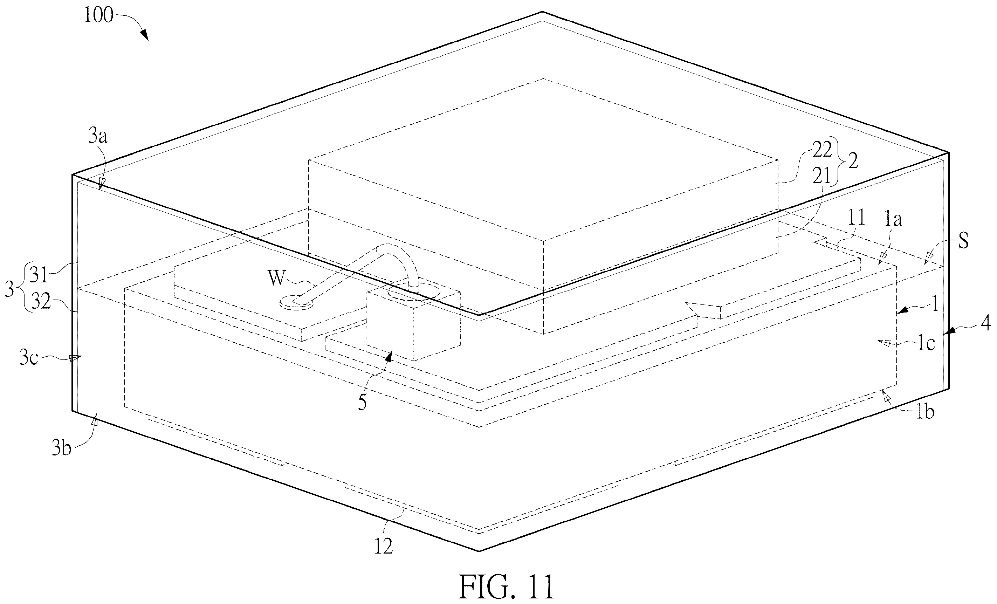

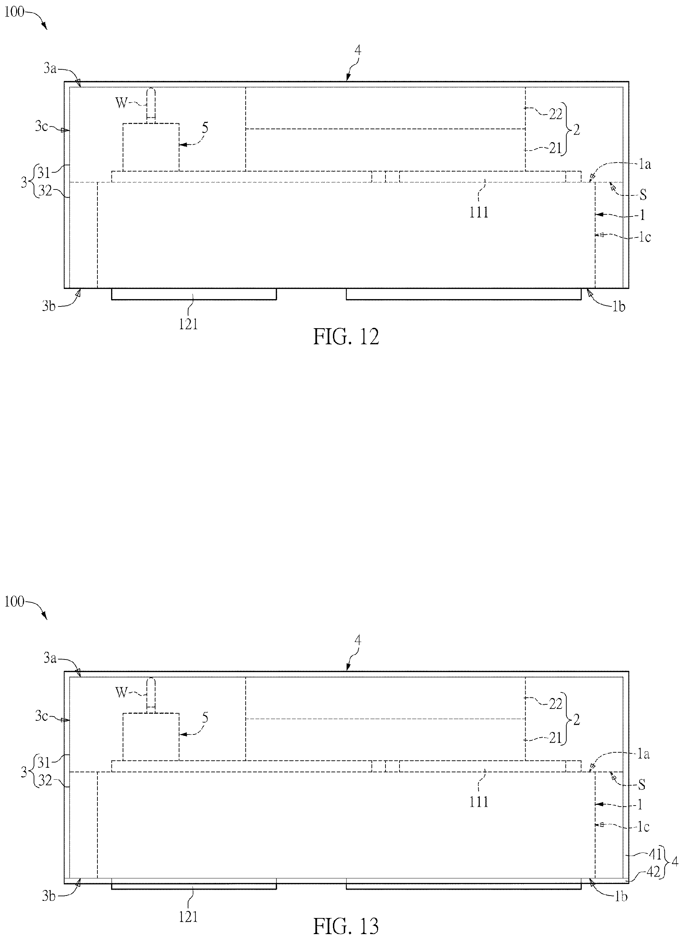

Referring to FIG. 11 and FIG. 12, FIG. 11 is a schematic perspective view of a light-emitting package structure according to a seventh embodiment of the present invention, and FIG. 12 is a schematic side view of the light-emitting package structure according to the seventh embodiment of the present invention. In the seventh embodiment of the present invention, the light-emitting layer 4 covers the light-emitting module 2 and the second top surface 3a and the second side surfaces 3c of the encapsulant 3. In other words, the light-emitting layer 4 covers the light-emitting module 2, a plurality of side surfaces of the first encapsulant 41, the surface of the first encapsulant 31 away from the second encapsulant 32, and a plurality of side surfaces of the second encapsulant 32.

Referring to FIG. 13, FIG. 13 is a schematic side view of a light-emitting package structure according to an eighth embodiment of the present invention. In an eighth embodiment of the present invention, the light-penetrable layer 4 includes a first light-penetrable layer 41 and a second light-penetrable layer 42, the first light-penetrable layer 41 covers the light-emitting module 2 and the second top surface 3a and the second side surfaces 3c of the encapsulant 3, and the second light-penetrable layer 42 is connected to the first light-penetrable layer 41 and covers the second bottom surface 3b of the encapsulant 3.

In other words, the first light-penetrable layer 41 covers the light-emitting module 2, the surface of the first encapsulant 31 away from the second encapsulant 32, the side surfaces of the first encapsulant 31, and the side surfaces of the second encapsulant 32, and the second light-penetrable layer 42 is connected to the first light-penetrable layer 41 and covers the surface of the second encapsulant 32 that is away from the first encapsulant 31. In addition, the second light-penetrable layer 42 can further cover the first bottom surface 1b of the substrate 1.

### [Method for Producing a Light-Emitting Package Structure]

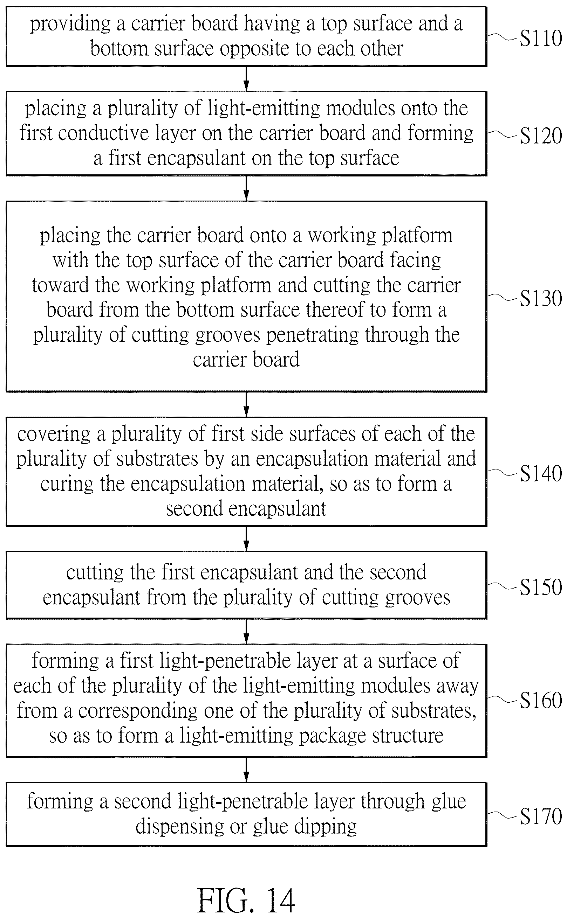

Referring to FIG. 14, FIG. 14 is a flow chart of a method for producing a light-emitting package structure according to a ninth embodiment of the present invention. A ninth embodiment of the present invention provides a method for producing a light-emitting package structure. The method for producing the light-emitting package structure includes a preparing process S110, a first packaging process S120, a first cutting process S130, a second packaging process S140, a second cutting process S150, and a first light-penetrable layer forming process S160. Naturally, the method for producing the light-emitting package structure can include other process according to practical requirements, but the present invention is not limited thereto.

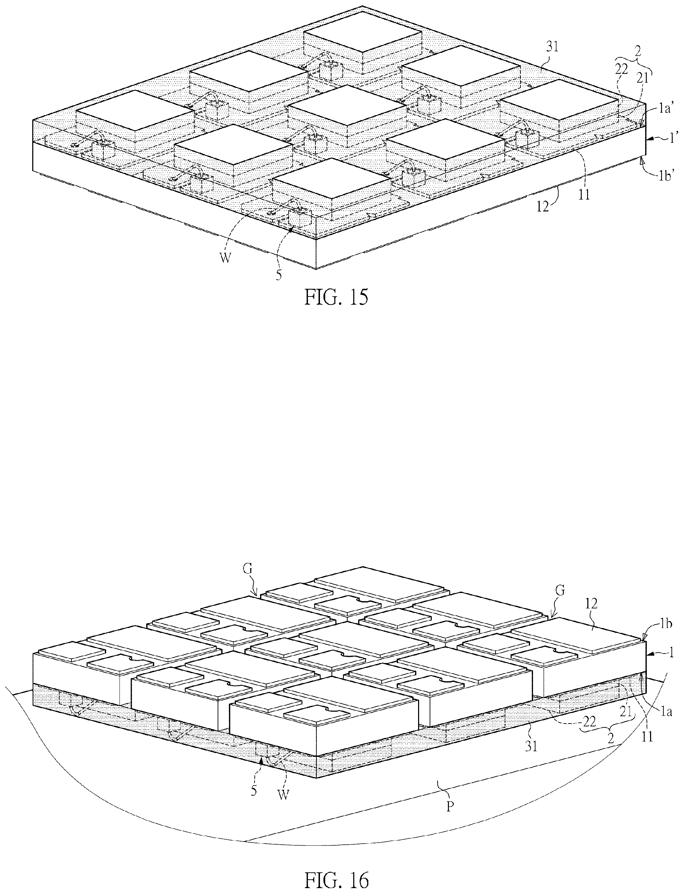

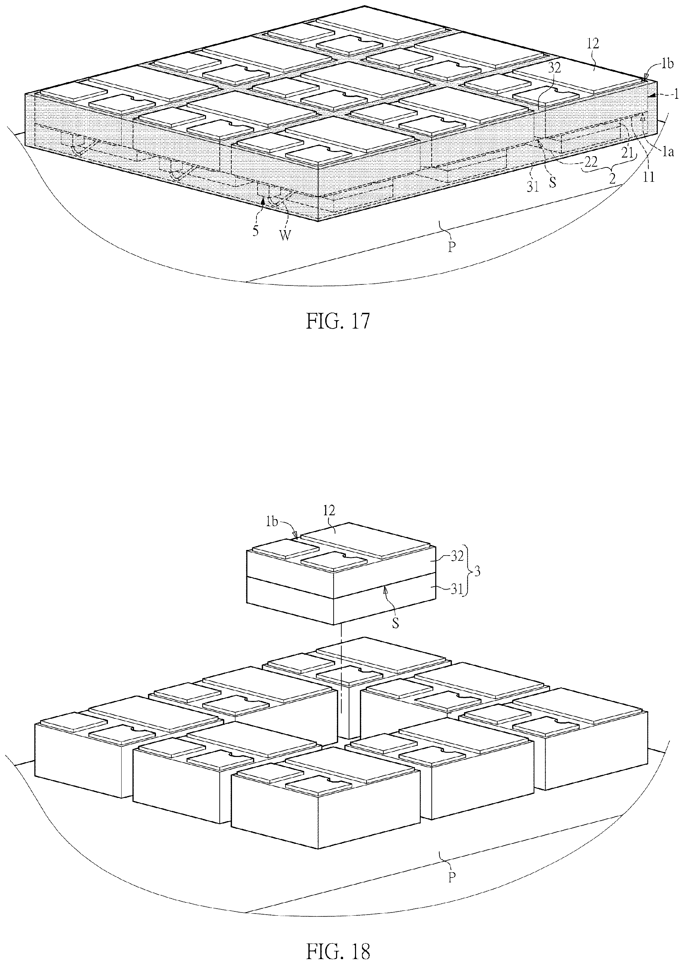

Referring to FIG. 14 and in cooperation with FIG. 15 to FIG. 18, FIG. 15 is a schematic view showing a first packaging process of the method for producing the light-emitting package structure according to the ninth embodiment of the present invention, FIG. 16 is a schematic view showing a first cutting process of the method for producing the light-emitting package structure according to the ninth embodiment of the present invention, FIG. 17 is a schematic view showing a second packaging process of the method for producing the light-emitting package structure according to the ninth embodiment of the present invention, and FIG. 18 is a schematic view showing a second cutting process of the method for producing the light-emitting package structure according to the ninth embodiment of the present invention.

The preparing process S110 is implemented by providing a carrier board 1' having a top surface 1a' and a bottom surface 1b' opposite to each other. The carrier board 1' can be cut (e.g., through the first cutting process S130) to form the above-mentioned substrate 1, and the top surface 1a' and the bottom surface 1b' of the carrier board 1' can be regarded as the first top surface 1a and the first bottom surface 1b of the substrate 1. The carrier board 1' has a first conductive layer 11 and a second conductive layer 12 respectively formed on the top surface 1a' and the bottom surface 1b'.

As shown in FIG. 15, the first packaging process S120 is implemented by placing a plurality of light-emitting modules 2 onto the first conductive layer 11 on the carrier board 1' and forming a first encapsulant 31 on the top surface 1a'. The first encapsulant 31 can cover a plurality of side surfaces of each of the light-emitting modules 2. The first encapsulant 31 can be flush with the surface of each of the light-emitting modules 2 that is away from the carrier board 1', but the present invention is not limited thereto. In addition, before the first packaging process S120, an annular wall (not shown in the drawings) can be formed on the top surface 1a' of the carrier board 1', and in the first packaging process S120, an encapsulation material can be filled into a space surrounded by the annular wall to form the first encapsulant 31, but the present invention is not limited thereto.

As shown in FIG. 16, the first cutting process S130 is implemented by placing the carrier board 1' onto a working platform P with the top surface 1' of the carrier board 1 facing toward the working platform P and cutting the carrier board 1 from the bottom surface 1b' thereof, so as to form a plurality of cutting grooves G penetrating through the carrier board 1'. After the first cutting process S130, the carrier board 1' is formed into a plurality of substrates 1, and each of the plurality of substrates 1 has a first top surface 1a and a first bottom surface 1b opposite to each other.

Specifically, in the first cutting process 130, the carrier board 1' can be flipped, such that the top surface 1a' of the carrier board 1' faces toward the working platform P. It is worth mentioning that, in the first cutting process S130, the first encapsulant 31 is arranged between the carrier board 1' and the working platform P to provide a supporting force. In addition, in the first cutting process S130 of other embodiments, a supporting board (not shown in figures) can be disposed on the working platform P, and the first encapsulant 31 can be disposed on the supporting board.

In the first cutting process S130 of one embodiment, the carrier board 1' is cut by a first cutting tool with a kerf width of between 0.3 mm and 0.5 mm, but the present invention is not limited thereto.

As shown in FIG. 17, the second packaging process S140 is implemented by covering a plurality of first side surfaces 1c of each of the substrates 1 by an encapsulation material and curing the encapsulation material, so as to form a second encapsulant 32. The first encapsulant 31 is connected to the second encapsulant 32, and an interface S is formed between the first encapsulant 31 and the second encapsulant 32.

In addition, in the second packaging process S140, the encapsulation material can be cured at a temperature of between 120 and 180°C to form the second encapsulant 32. It is worth mentioning that, the encapsulation material that forms the first encapsulant 31 can be the same as or different from the encapsulation material that forms the second encapsulant 32. In the present embodiment, the encapsulation material can be, for example, an epoxy resin or a white glue, but the present invention is not limited thereto.

It is worth mentioning that, in the second packaging process S140, each of the substrates 1 is packaged from the first bottom surface 1b (or the cutting grooves G), and accordingly, the second encapsulant 32 can be prevented from covering onto the second conductive layer 12.

As shown in FIG. 18, the second cutting process S150 is implemented by cutting the first encapsulant 31 and the second encapsulant 32 from the plurality of cutting grooves G. In the second cutting process S150 of one embodiment, the first encapsulant 31 and the second encapsulant 32 is cut by a second cutting tool with a kerf width of between 0.1 mm and 0.3 mm. In other words, the kerf width formed by the first cutting tool in the first cutting process S 130 is less than or equal to the kerf width formed by the second cutting tool in the second cutting process S150. In addition, after the second cutting process S150, the substrate 1 having the first encapsulant 31 and the second encapsulant 32 formed thereon can be detached from the working platform P.

The first light-penetrable layer forming process S160 is implemented by forming a first light-penetrable layer 41 at a surface of each of the light-emitting modules 2 away from a corresponding one of the substrates 1, so as to form a light-emitting package structure 100 (as shown in FIG. 8 and FIG. 9) or a plurality of the light-emitting package structure 100. In the first light-penetrable layer forming process S160 of other embodiments, the first light-penetrable layer 41 can be formed only on the surface of the light-emitting modules 2 away from the substrate 1, but the present invention is not limited thereto.

In the first light-penetrable layer forming process S160 of one embodiment, the first light-penetrable layer 41 is formed through spraying, dispensing, brushing, or dipping. In addition, in the present embodiment, the first light-penetrable layer 41 (as shown in FIG. 11 and FIG. 12) covers a plurality of side surfaces of the first encapsulant 31, a plurality of side surfaces of the second encapsulant 32, and a surface of the first encapsulant 31 that is away from the second encapsulant 32.

In the first light-penetrable layer forming process S160 of one embodiment, the first light-penetrable layer 41 can be alternatively formed through immersing the side surfaces of the first encapsulant 31, the side surfaces of the second encapsulant 32, and the surface of the first encapsulant 31 that is away from the second encapsulant 32 into a light-penetrable solvent.

After the first light-penetrable forming process S160, the method for producing the light-emitting package structure can further include a second light-penetrable layer forming process S170 implemented by forming a second light-penetrable layer 42 through glue dispensing or glue dipping. In the present embodiment, the second light-penetrable layer 42 (as shown in FIG. 13) is connected to the first light-penetrable layer 41, and the second light-penetrable layer 42 covers the first bottom surface 1b of one of the substrates 1 and a surface of the second encapsulant 32 that is away from the first encapsulant 31.

Referring to FIG. 19, FIG. 19 is a schematic view showing a first cutting process of a method for producing a light-emitting package structure according to a tenth embodiment of the present invention. In the first cutting process S130 of a tenth embodiment of the present invention, the carrier board 1' and the first encapsulant 31 are cut from the bottom surface 1b' of the carrier board 1', so as to form the cutting grooves G penetrating through the carrier board 1' and a plurality of connection grooves 311 that are recessed in the first encapsulant 31. In the present embodiment, a depth D of each of the connection grooves can be between 0.01 mm and 0.1 mm, but the present invention is not limited thereto.

Referring to FIG. 20, FIG. 20 is a schematic view showing a second packaging process of the method for producing the light-emitting package structure according to the tenth embodiment of the present invention. In the second packaging process S140 of the tenth embodiment, the encapsulation material is filled into the cutting grooves G and the connection grooves 311, and the encapsulation material is cured to form the second encapsulant 32. In this way, a contact surface between the first encapsulant 31 and the second encapsulant 32 can be increased, and the first encapsulant 31 and the second encapsulant 32 have a better combination there-between.

### [Beneficial Effects of the Embodiments]

In conclusion, in the light-emitting package structure and method for producing the same provided by the present invention, by virtue of "the encapsulant covering the first top surface, the first conductive layer, and the plurality of first side surfaces of the substrate," the problem of the encapsulant in the conventional light-emitting package structure having an insufficient protective effect provided by the encapsulant in the conventional light-emitting package structure, since the side surfaces of the substrate are usually not covered by the encapsulant, can be effectively improved.

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to enable others skilled in the art to utilize the invention and various embodiments and with various modifications as are suited to the particular use contemplated.

## Claims

1. A light-emitting package structure (100), **characterized in that** the light-emitting package structure (100) comprises:
a substrate (1) having a first top surface (1a) and a first bottom surface (1b) opposite to each other and a plurality of first side surfaces (1c), wherein a first conductive layer (11) is formed on the first top surface (1a) and a second conductive layer (12) is formed on the first bottom surface (1b);
a light-emitting module (2) disposed on the first conductive layer (11); and
an encapsulant (3) covering the first conductive layer (11), a plurality of side surfaces of the light-emitting module (2), and the first top surface (1a) and the plurality of first side surfaces (1c) of the substrate (1).

2. The light-emitting package structure (100) according to claim 1, further comprising a light-penetrable layer (4) disposed on a surface of the light-emitting module (2) that is away from the substrate (1).

3. The light-emitting package structure (100) according to claim 1, wherein a second top surface (3a) of the encapsulant (3) and a surface of the light-emitting module (2) that is away from the substrate (1) are co-planar.

4. The light-emitting package structure (100) according to claim 1, wherein the light-emitting module (2) includes a light-emitting member (21) and a light-penetrable member (22), and the light-emitting member (21) is disposed between the substrate (1) and the light-penetrable member (22), and wherein the light-emitting member (21) is configured to emit a first light beam with a first wavelength between 10nm and 780nm, and the first light beam passes through the light-penetrable member (22) and is formed into a second light beam with a second wavelength.

5. The light-emitting package structure (100) according to claim 4, wherein the first wavelength is between one of the following ranges: 10 nm and 420 nm; 270 nm and 420 nm; 380 nm and 780 nm; 422 nm and 457.5 nm.

6. The light-emitting package structure (100) according to claim 4, wherein the first wavelength is between 10 nm and 420 nm and the second wavelength is between 380 nm and 780 nm.

7. The light-emitting package structure (100) according to claim 4, wherein the second wavelength is substantially equivalent to the first wavelength.

8. The light-emitting package structure (100) according to claim 1, wherein the encapsulant (3) further covers the first bottom surface (1b), and the second conductive layer (12) is exposed from the encapsulant (3).

9. The light-emitting package structure (100) according to claim 8, wherein the encapsulant (3) covers a plurality of side surfaces of the second conductive layer (12).

10. The light-emitting package structure (100) according to claim 2, wherein a refractive index of the light-penetrable layer (4) is between 1.2 and 1.6.

11. The light-emitting package structure (100) according to claim 2, wherein the light-penetrable layer (4) covers a surface of the light-emitting module (2) that is away from the substrate (1) and a second top surface (3a) of the encapsulant (3).

12. The light-emitting package structure (100) according to claim 11, wherein the light-penetrable layer (4) further covers a plurality of second side surfaces (3c) of the encapsulant (3).

13. The light-emitting package structure (100) according to claim 2, wherein the light-penetrable layer (4) includes a first light-penetrable layer (41) and a second light-penetrable layer (42), the first light penetrable layer (4) covers a surface of the light-emitting module (2) that is away from the substrate (1), as well as a second top surface (3a) and a plurality of second side surfaces (3c) of the encapsulant (3), and the second light-penetrable layer (42) is connected to the first light-penetrable layer (41) and covers a second bottom surface (3b) of the encapsulant (3).

14. The light-emitting package structure (100) according to claim 1, wherein the encapsulant (3) includes:
a first encapsulant (31) covering the first top surface (1a), the first conductive layer (11), and the light-emitting module (2); and
a second encapsulant (32) covering the plurality of first side surfaces (1c), wherein the first encapsulant (31) is connected to the second encapsulant (32), and an interface (S) is formed between the first encapsulant (31) and the second encapsulant (32).

15. The light-emitting package structure (100) according to claim 14, wherein a top surface of the first encapsulant (31) and a surface of the light-emitting module (2) that is away from the substrate (1) are co-planar.

16. The light-emitting package structure (100) according to claim 14, wherein the second encapsulant (32) further covers the first bottom surface (1b), and the second conductive layer (12) is exposed from the second encapsulant (32).

17. The light-emitting package structure (100) according to claim 16, wherein the second encapsulant (32) covers a plurality of side surfaces of the second conductive layer (12).
